# EUROPEAN PATENT APPLICATION

(11) **EP 1 883 115 A1**
(43) Date of publication of application: **30.01.2008**
(21) Application number: 06118063.4
(22) Date of filing: 28.07.2006
(51) Int. Cl.: H01L 29/778

(54) **An enhancement mode field effect device and the method of production thereof**

(71) Applicant: Interuniversitair Microelektronica Centrum (IMEC), 3001 Leuven (BE); KATHOLIEKE UNIVERSITEIT LEUVEN, 3000 Leuven (BE)
(72) Inventor: Derluyn, Joff, 1000, BRUSSEL (BE); Boeykens, Steven, 2890, SINT-AMANDS (BE); Germain, Marianne, 4000, LIÈGE (BE); Borghs, Gustaaf, 3010, KESSEL-LO (BE)
(74) Representative: pronovem

(57) **Abstract**

The present invention is related to a method for producing Group III-N field-effect devices, such as HEMT, MOSHFET, MISHFET or MESFET devices, comprising two active layers, e.g. an GaN/AlGaN layer. The method produces an enhancement mode device of this type, i.e. a normally-off device, by providing a passivation layer on the AlGaN layer, etching a hole in said passivation layer, and depositing the gate contact in said hole, while the source and drain are deposited directly on the passivation layer. The characteristics of the active layers and/or of the gate are chosen such that no two-dimensional electron gas layer is present underneath the gate, when a zero voltage is applied to the gate. The invention is equally related to a device with this behaviour.

## Description

### Field of the Invention

The present invention is related to group III-nitride field effect devices (e.g. comprising a GaN/AlGaN layer) and methods to produce an enhancement mode device of this type, i.e. a normally-off device, in which no current can flow between source and drain contact unless a positive voltage is applied to the gate.

### State of the Art

Field effect devices of the type described above, e.g. High Electron Mobility Transistors (HEMT) comprise a two-dimensional electron gas (2 DEG) between two active layers, e.g. between an GaN layer and a AlGaN layer deposited on a Si substrate. This 2DEG layer is a consequence of piezoelectric polarization leading to charge separation within the materials. In known devices of this type, the 2DEG is present at zero gate bias due to the characteristics of the materials. GaN field effect transistor devices (FET) with contacts formed on top of the AlGaN layer are normally-on devices. The formation of contacts on the AlGaN does not change the charge polarization in the heterostructure so that if there was a 2DEG present before processing, it will remain there after formation of contacts on top of the AlGaN. A certain negative voltage, called threshold voltage, on the gate is needed to deplete the 2DEG through capacitive coupling. By applying a negative voltage to the gate, the electron channel can be pinched off. This negative voltage is typically below a negative threshold voltage (*Vth*)*,* typically between -4 and -8 V. These transistors work in depletion-mode (D-mode): the channel has to be depleted to switch off the transistor.

In document EP-A-1612866, a passivation layer is proposed on top of the device to solve several problems. It is intended to protect the surface of the GaN from contamination by air exposure. Furthermore, the passivation is able to stabilise the surface states of the AlGaN surface. This reduces the DC-to-RF dispersion and consequently increases the switching frequency. The passivation layer also improves the reproducibility of the device because it limits modifications of the top surface charge that influence the charge density in the 2DEG. One of the main characteristics for power switching devices in the linear operating regime is the on-state resistance. This is determined essentially by the value of the contact resistance of the Ohmic source and drain contacts, as well as by the sheet resistance of the 2DEG channel. To minimize losses, this on-state resistance should be minimal. The passivation layer mentioned in EP-A-1612866 allows for a better Ohmic contact formation. Also, a higher current density is achieved because the passivation layer on top of the AlGaN-layer has characteristics that increase the two-dimensional electron gas by introducing a higher strain in the heterostructure when compared to the device without this passivation layer.

For certain applications, such as power switching or integrated logic, a negative-polarity gate voltage supply is unwanted: the gate control of power devices in e.g. power supplies should be made similar to that used for Si devices. Field-Effect Transistors (FET) with a threshold voltage Vth = 0V are normally-off devices. At zero gate voltage, no channel is present to conduct current. These transistors work in enhancement-mode (E-mode). E-mode transistors are attractive for normally-off power switches, for digital electronics applications, and for high efficiency RF applications.

To make a normally-off device, i.e. a device where no current can flow between source and drain contact when the gate is floating or grounded, one can interrupt the channel selectively under that gate contact while at the same time preserving as high as possible 2DEG density in the other regions. A positive threshold voltage will then induce 2DEG under the gate contact, allowing current to flow between source and drain. Several methods have been reported to achieve such an enhancement mode transistor:
- selectively regrown p-n junction for the gate (X. Hu, G. Simin, J. Yang, M.A. Khan, R. Gaska, M.S. Shur, "Enhancement mode AlGaN/GaN HFET with selectively grown pn junction gate" , Elec. Lett. Vol. 36, No. 8, pp. 753-754, 2000),
- CF4 plasma treatment of the AlxGa1-xN (Y. Cai, Y. Zhou, K.J. Chen, K.M. Lau, "High-performance enhancement-mode AlGaN/GaN HEMTs using fluoride-based plasma treatment" , IEEE Elec. Dev. Lett. Vol. 26, No. 7, pp. 435-437, 2005)
- gate recess techniques with or without post-etch RTA treatment (V. Kumar, A. Kuliev, T. Tanaka, Y. Otoki, I. Adesida, "High transconductance enhancement-mode AlGaN/GaN HEMTs on SiC substrate" , Elec. Lett. Vol. 39, No. 24, pp. 1758-1759, 2003 and W.B. Lanford, T. Tanaka, Y. Otoki, I. Adesida, "Recessed gate enhancement mode GaN HEMT with high threshold voltage" , Elec. Lett. Vol. 41, No. 7, pp. 449-450, 2005)
In the last case, part of the AlGaN layer is selectively removed under the gate contact. As a result the remaining AlGaN is not thick enough and is not sufficiently strained relative to the GaN to create a 2DEG in between the two materials. However, a recessed gate is not a straightforward implementation. Since wet etching cannot be applied on AlxGa1-xN (no chemical etchant is known to have a significant etch rate on AlxGa1-xN), one needs to resort to dry etching techniques to remove the AlGaN (and III-nitrides in general). Plasma-assisted dry etching can be done. Dry etching of group-III nitrides is however not selective of one material composition to another. The etch rate for the typically used Cl₂-based plasma is difficult to control and reproduce. The minimum etch rate obtained at the moment is around 100 nm/min, being still too high to reproducibly etch the AlₓGa₁₋ₓN top layer from the 22 nm thickness to exactly 5 nm. Moreover, dry etching of group-III nitrides is known to cause an increase in the density of surface states which in their turn cause dispersion effects. Dry etching introduces a lot of defect states, resulting in a Schottky gate with high leakage current. A possible solution is an RTA anneal after the etch step. This, however, introduces yet another extra processing step, with a critical gate alignment step.

### Aims of the Invention

The present invention aims to provide an enhancement mode (i.e. normally-off) field effect transistor device that overcomes the etching problem encountered in other enhancement mode transistors.

### Summary of the Invention

The invention is related to a device and method as described in the appended claims. The method of the invention allows to produce group III- Nitride enhancement mode field-effect devices, like high electron mobility transistor (HEMT), metal insulator semiconductor heterostructure field effect transistor (MISHFET) or metal oxide semiconductor heterostructure field effect transistor (MOSHFET) or metal semiconductor field effect transistor (MESFET) devices. This invention overcomes the etching problem encountered in other enhancement mode transistors. The controllability of the fabrication process is much improved. A low on-state resistance of the device is achieved, i.e. a high channel current density, in combination with low Ohmic contact resistances. Also the creation of surface states is minimized and the passivation of surface states is preserved.

### Brief Description of the Drawings

Figure 1 represents a High electron mobility transistor (HEMT) according to the invention.

Figure 2 represents a Metal insulator semiconductor heterostructure field effect transistor (MISHFET) or metal oxide semiconductor heterostructure field effect transistor (MOSHFET) according to the invention.

Figure 3: Sheet resistance of HEMT's with/without Si₃N₄.

Figure 4: Procedure to obtain the threshold voltage Vₜₕ: at maximum of gₘ. The slope of the I_{ds} curve is extrapolated to 0 where the intercept gives Vₜₕ.

Figure 5: Vₜₕ as function of AlₓGa₁₋ₓN thickness for Si₃N_{4/}AlₓGa₁₋ₓN/AlN/GaN heterostructures.

Figure 6: I_{DS} - V_{GS} curve for AlₓGa₁₋ₓN/AlN/GaN E-mode HEMTs.

### Detailed Description of the Invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

In the context of the present invention and except if specified otherwise, the term 'on' when referring to the relative position of two layers, can mean 'directly or immediately on' (i.e. without intermediate layer) or can also mean 'above, with one or more intermediary layers'.

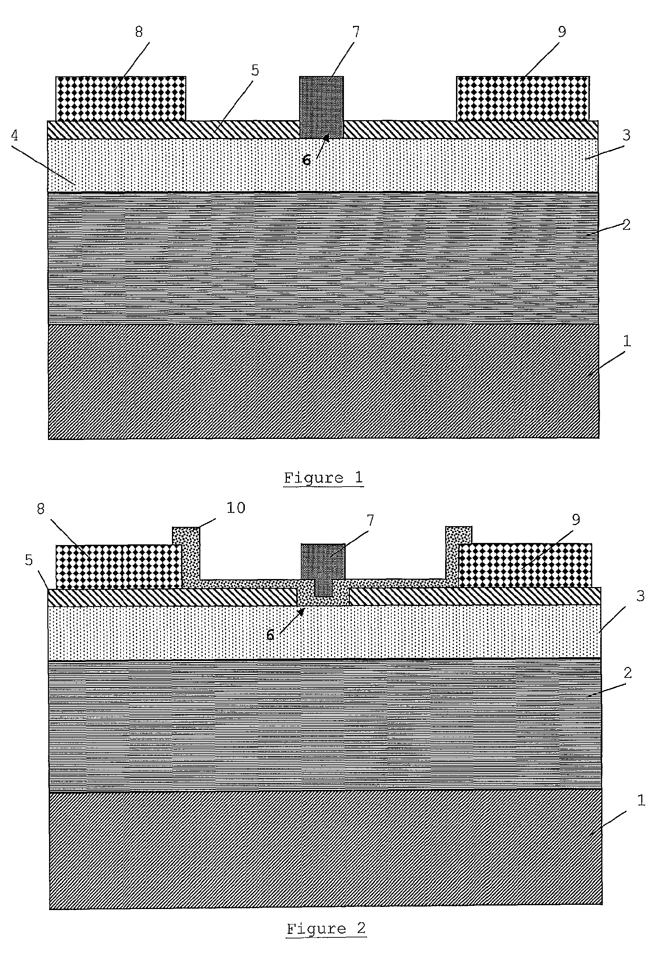

According to the method of the invention and with reference to figure 1, a substrate (1), e.g. a sapphire substrate, is placed in a reaction chamber (not shown). A first active layer (2), e.g. a GaN layer, is deposited on the substrate, and a second active layer (3), e.g. an AlGaN layer, is deposited on the first active layer. In general, the second active layer (3) has a higher band-gap when compared to the first active layer. Alternative materials for the substrate and first and second active layers are given further in this description, as well as possible techniques for depositing the layers. Depending on the thickness, the composition and the loading effects on the surface of the second active layer (3), a two-dimensional electron gas (2 DEG) may appear at the interface (4) between the two active layers. According to a first embodiment, the thickness, the composition and the loading effects on the surface of the second active layer (3) are chosen such that no 2DEG at the interface between the two active layers is created. One way of obtaining this result is e.g. to choose the second active layer to be thinner than a predefined minimum thickness. The result is that the 2DEG at the interface between the two active layers is absent. The physical conditions to induce a highly conductive 2DEG between the first and the second active layer are not met without further process steps or extra layers.

A passivation layer (5) is then deposited on the second active layer (3). The deposition parameters and the composition of the passivation layer are chosen such that a two-dimensional electron gas is created between the first and the second active layer after the deposition of the passivation layer. A possible way to obtain this effect is an in-situ deposition of the passivation layer immediately after the deposition of the second active layer. With 'in situ' is meant that the passivation layer is applied before cooling down the device, for example by depositing the passivation layer in the same reaction chamber as the deposition of the first and second active layer. That way the strain-induced modifications during cooling down are reduced. Consequently, a higher strain is introduced in the heterostructure without damaging the mechanical properties of the second active layer. Consequently 2 DEG is created in between the first and second active layer. This procedure is described in document EP-A-1612866, included herein by reference.

The 2DEG is then interrupted by etching holes (6) in the passivation layer. Possibly a thin passivation layer may still be present at the bottom of the holes. At the locations where the passivation layer is etched, the strain in the second active layer is releaved and consequently, the 2DEG layer is removed at the locations where the holes are etched. This allows removing the 2DEG layer under the holes in the passivation layer while at the same time preserving as high as possible 2DEG density in the other regions. Still according to the first embodiment, a gate (7) is deposited in the holes in the passivation layer and possibly partially on top of the passivation layer, a source (8) and a drain (9) electrode are deposited in electrical contact with the passivation layer (5). The production of the gate does not influence the 2DEG layer : underneath the gate, no 2DEG layer is present. Because of the absence of a 2DEG layer underneath the gate (7), no current will flow between source and drain contact when the gate is floating or grounded. A positive voltage above a threshold voltage will induce 2DEG under the gate contact, allowing current to flow between source and drain. In this way, an enhancement mode (normally off) transistor is created. In the first embodiment, it is preferred to remove the complete thickness of the passivation layer to form the holes (6). However, it also possible to remove only a part of the thickness of the passivation layer, in other words to remove a sufficient volume of said passivation layer to result in the absence of a 2DEG layer underneath the holes (6).

According to a second embodiment, after the deposition of the second active layer, a 2DEG, preferably a low density 2DEG is nevertheless present between the first and second active layer. This may be the case e.g. when the second active layer is slightly thicker than said predefined minimum thickness. In the same way as in embodiment 1, a passivation layer is deposited in-situ on the second active layer, thereby enhancing the 2DEG in between first and second active layer.

According to the second embodiment, hole(s) (6) are also etched in the passivation layer, but due to the characteristics of the first and second active layers, a 2DEG is still present at the location of these holes. Still according to this second embodiment, a gate is deposited in the holes, and source and drain contacts are produced on the passivation layer. According to one aspect of the second embodiment however, the work function of the gate is chosen such that the 2DEG underneath said gate is eliminated (this effect is e.g. described in 'Power Electronics no InAnN/(In)GaN prospect for a record performance', J. Kuzmik, IEEE Electron Device letters, vol. 22, N° 11, Nov. 2001, included herein by reference). According to another aspect of the second embodiment, this elimination is obtained by creating suitable surface states through a plasma treatment (this effect is e.g. described by Y. Cai in 'High-performance enhancement-mode AlGaN/GaN HEMTs using fluoride-based plasma treatment', IEEE Electron Device Letters, Vol. 26, No. 7, July 2005, included herein by reference). In the latter case, the whole thickness of the passivation layer must be removed in the holes (6). Therefore also according to the second embodiment, an enhancement mode device is obtained. According to still another aspect of the second embodiment, this elimination can be obtained by etching these holes through the passivation layer and partially into the second active layer such that the strain in the second active layer is releaved and consequently, the 2DEG layer is removed at these locations (this effect is e.g. described by W.B. Lanford, T. Tanaka, Y. Otoki, I. Adesida, in "Recessed gate enhancement mode GaN HEMT with high threshold voltage", Elec. Lett. Vol. 41, No. 7, pp. 449-450, 2005).

According to both embodiments, because the passivation is still present underneath the source and drain, a 2 DEG will be present underneath source and drain and the channel between source and drain is completed when a positive voltage is applied to the gate. The passivation layer underneath the source and the drain allows reducing the Ohmic contact for source and drain.

More details on possible materials, process parameters, deposition methods, extra layers, etc. are given below.

The substate (1) may consist of any material that can be used as a substrate for III-V processing, such as silicon, sapphire (Al₂O₃), SiC, GaN, AlN, GaAs or diamond. Also substrates comprising one or more of these materials can be used, such as silicon on insulator or GaN on diamond. Consequently a first (2) and second (3) active layer need to be deposited on top of the substrate (1). To facilitate the growth and to increase the quality of these active layers, extra layers can be included.

A nucleation layer (not shown) can be grown on the substrate (1). This nucleation layer acts as a transition layer between substrate and active layers. It permits the start of epitaxial growth on substrates that are chemically and structurally (very) different from the epitaxial layers by first creating isolated islands of deposited layers which later coalesce in a single layer. Typically the nucleation layer comprises or consists of GaN, AlGaN or AlN and has a thicknesses between 1nm and 100nm.

A buffer layer (not shown) can be produced on the nucleation layer. As the nucleation layer may be defective, an intermediate buffer layer may be needed to decrease the defect density in the active layers. This buffer layer can comprise one or more layers such as a layer comprising or consisting of GaN, AlGaN or AlN. The thickness of these layers varies between 20nm and 500nm and allows bending of propagating threading dislocations away from the vertical growth directions. The properties of the nucleation and buffer layer directly influence the properties of the active layers, e.g. in terms of dislocation density and material resistivity.

The first and/or second active layers (2,3) can be group III nitride semiconductor material. The first active layer can comprise or consist of GaN, AlGaN, InGaN, InAlGaN, BN or combinations thereof. The second active layer can comprise or consist of AlGaN, AlInN, and InAlGaN. When the active layers comprise several of the elements listed above, they are built from several layers of said respective elements, deposited one on top of the other. The bandgap of the second active layer needs to be higher than the bandgap of the first active layer. Often the first active layer is a GaN layer and the second active layer is an AlGaN layer. In between the first and second active layer, a spacer can be deposited. Such spacer layer repulses the electron wave function out of the AlGaN into the GaN away from the interface between the two layers. In this way, the electron wave function overlaps less with possible interface roughness or electrical roughness caused by compositional non-uniformity. Hence scattering is reduced which in turn increases the electron mobility. In the best case the spacer has a high bandgap and is very thin, for example around 1 nm or even less. The spacer can be AlN.

Also a a third active layer (not shown) may be produced under the first active layer, i.e. applied on the substrate or on the nucleation layer or on the buffer layer, prior to the production of the first active layer. The third active layer can have a higher bandgap than the first active layer. This third active layer can comprise a group III nitride material. The third active layer can comprise or consist of AlGaN, AlN, InAlGaN or InAlN. The thickness can be between 50nm and 2µm thick. Its higher bandgap prevents electrons from entering this layer during pinch-off so that they cannot be caught in traps which would lead to dispersion effects.

Before deposition of the passivation layer, the second active laye can be provided with a doping element. For example, an AlGaN layer can be doped with Si, in the order of 10¹⁷ to 10¹⁹ Si-atoms/cm³. This doping can be applied in order to improve the ohmic contacts.

The passivation layer (4) preferably comprises an electron donating element and nitrogen for passivating the surface states. The passivation layer can comprise or consist of SiN, BN, Si, CN or GeN. The thickness can be chosen between 1nm and 5000nm. In the best case the thickness of the passivation layer is in between 3nm and 20nm.

For the deposition of the first and second (and third) active layers and of the passivation layer, in particular of a GaN, AlGaN and a SiN layer, Metal Organic Chemical Vapor Deposition growth (MOCVD) can be used. Alternatively, molecular beam epitaxy (MBE) can be used. The creation of a 2 DEG layer is influenced by the thickness, the composition and the loading effects at the surface of the second active material. When a combination of GaN and AlGaN is used, the thickness and Al concentration are determining parameters for the presence or absence of a 2 DEG layer. The thickness of the second active layer can be chosen between 1 and 10 nm, in the best case between 3 and 5 nm, for example in case of AlGaN on GaN.

As mentioned above, the passivation layer (5) should be deposited such that a 2 DEG is created or enhanced between the two active layers. A possible way to obtain this effect is an in-situ deposition of the passivation layer immediately after the deposition of the second active layer. 2 DEG is created or enhanced from the additional strain introduced by the in-situ deposition of the passivation layer. For the deposition of GaN, AlGaN and SiN layer, MOCVD growth can be used, so the passivation layer can be deposited in-situ by MOCVD in an MOCVD reaction chamber. The deposition is done at high temperature (>1000C). After deposition, the reaction chamber is cooled down and the device is removed from the reaction chamber. That way it induces additional strain in the AlGaN layer and the strain-induced modifications during cooling down are reduced. This creates or enhances the 2DEG at the interface between the first active layer and the second active layer, for example at the GaN/AlGaN interface. That way it allows obtaining a high 2DEG density for very thin AlGaN layers.

One or more holes (6) are etched in the passivation layer. The controllability of the fabrication process can be improved by etching the passivation layer selectively with respect to the underlying active material. In case a SiN passivation is used on top of AlGaN, removing the passivation selectively to AlGaN can be done by wet etching, e.g. in HF. HF does not etch the AlGaN nor influences the surface states. Besides using boiling KOH, it is nearly impossible to wet etch AlGaN. So any other chemical that etches Si₃N₄ (e.g. using HF, buffered HF, HCI) will cause a selectivity of the etching process of at least two orders of magnitude. Removing the passivation selective to AlGaN can also be done using a selective dry etching process, e.g. by SF6/Ar plasma in a RIE/ICP system. The etching rate of SiN can be at least one order of magnitude higher than that of AlGaN.

The gate (7) is deposited in the holes in the passivation layer. A gate contact will be present where the passivation has been removed, i.e. filling the complete width of the hole (6). The gate can eventually be a little wider, so partially located on the passivation layer. This contact is preferably a Schottky contact. Materials that can be used for the gate can be Ni, Pt, Mo, C, Cu, Au and other metals.

When the gate metallisation is defined using a lift-off process, the same resist as in the etching step of the passivation can be used, making the process self-aligned. Alternatively, patterning the gate can be done with lithography and dry etching.

According to both the first and second embodiment, an additional dielectric layer (10) may be deposited on the passivation layer after creation of the holes, and prior to deposition of the gate, so that said dielectric is present between the gate (7) and the second active layer (3) in the finished device. This is illustrated in Figure 2. The same structures can be found as described in Figure 1. The dielectric layer may comprise or consist of a high-k dielectric material, such as SiO2, Al203, Ta205, Hf02, Zr02, SiN or SiON. It can also comprise or consist of a combination of these materials. Any other dielectric material can be used. The dielectric layer is deposited after etching the holes, but before depositing the gate. The dielectric layer (10) can be located underneath the gate (7) and possibly on the passivation layer (5). As the strain state of this dielectric deposited using different techniques (PECVD, ALD, etc.) is well known, the process parameters can be chosen such that the strain state of the dielectric has a positive influence, limited influence, or no influence on the 2DEG layer. The dielectric layer (10) should not harm the operation of the device. This dielectric layer should not cover the source (8) and drain (9) contacts completely; in the preferred case it is not present on the source and drain contacts. The dielectric layer may be added as a solution to certain drawbacks of the normal Schottky contact by which the gate is formed (e.g. difficult to scale, high leakage current, reaction of metal with semiconductor).

Patterning to define the dielectric layer can be done by a lift-off technique or by completely covering the whole wafer and subsequent metal etching using photoresist as a mask. Also other methods for patterning known in the art can be used.

The source and drain contacts (8,9) may consist of a metal stack of three groups of metals, of which the first group is in direct contact with the passivation layer and the third group lies on top. The second group is a barrier in between the first and third group. The first group consists typically of Ti/Al or V/Al and forms the direct electric contact to the passivation layer. The third group consists of a metal that can prevent oxidation of the underlying materials (typically Au, WSi2). The second group consists of any material that can prevent mixing of the Au and Al (typically Mo, Ti, Ni, Pt), but can be removed in case the third group does not include Au.

Other processing steps may precede the processing described above, such as etching of mesa, and implantation. Furthermore other processing steps may follow, such as extra passivation on top of the first passivation layer, e.g. SiO2 on top of a SiN layer, airbridges, vias and other processing steps known in the art.

The invention is equally related to a device obtainable by the method of the invention. Such a device is illustrated in Figures 1 and 2. It basically comprises the following parts:
- A substrate (1),
- A first active layer (2), e.g. a GaN layer,
- A second active layer (3), e.g. a AlGaN layer,
- A passivation layer (5), e.g. a SiN layer,
- A source (8) and drain (9) contact on the passivation layer,
- At least one hole (6) in the passivation layer in between the source (8) and drain electrode (9),
- A gate electrode (7) in the hole(s),
- Possibly a dielectric layer (10) in between the gate electrode and the second active layer, e.g. a SiO2 layer,
- A two-dimensional electron gas (2DEG) located between the first and second active layer. The 2 DEG is absent underneath the hole in the passivation layer when the gate is floating or grounded, i.e. when a zero voltage is applied to the gate.

Possible alternative materials in the different layers and components of the device are described above with reference to the method of the invention. The device may equally comprise a nucleation layer, a buffer layer and/or a third active layer, produced from materials as described above with reference to the method of the invention.

The device can be put in the conductive state as follows. A voltage can be applied between source and drain contacts, such that the drain electrode has a higher potential when compared to the source electrode. A positive voltage (positive relative to the source contact potential) can be applied on the gate electrode above a threshold voltage. That way a 2 DEG can be created underneath the gate contact. Consequently a current between source and drain contacts can be realised. Changing the gate voltage modulates the source drain current which is essential for the transistor operation.

There are several applications for the device according to the current invention. The transistor can be integrated in a power switching circuit such that the current between source and drain can be controlled by a gate voltage that always remains positive. These circuits can operate at high frequencies and at high temperatures (power densities) and in harsh conditions. It is important for power circuitry that in case of faults, the circuit is automatically brought in a safe state and the devices are not destroyed. This is not the case for normally on HEMT's as when the gate would be accidentally brought to ground potential, the device would continue to conduct current. On top of that, normal operation no longer requires a negative voltage source which simplifies the design.

These transistors can be combined with transistors that do not have a positive threshold voltage to implement a logical circuit. These circuits can operate at high temperatures and in harsh conditions. Logic circuits are the basis for any digital electronic device. If this functionality were to be implemented in GaN, it would allow fro electronics that could operate at high operation temperatures (> 200C) and in acid or radiative environments.

### Description of a Preferred Embodiment of the Invention

A Thomas Swan close-coupled showerhead reactor was used with starting compounds trimethylgallium (TMGa), trimethylaluminium (TMAl), ammonia (NH₃) and silane (SiH₄ 200 ppm in hydrogen). The silane introduction line is modified in such a way that the amount of silane introduced in the reactor can be regulated from about 5 nmol/min up to about 1 mol/min. As a first step in the growth process, the sapphire substrates are annealed in H₂. Then, nitridation of the surface is carried out by introducing NH₃ into the reactor. After that, the substrates are cooled down to 525 °C and a thin GaN nucleation layer is grown. Subsequently, the temperature is ramped to 1020 °C, and at a pressure of 100 torr GaN is grown to a thickness of 2.6 um. On top of the semi-insulating GaN layer a thin (0.5 nm) AIN spacer layer is grown followed by an AlₓGa₁₋ₓN layer of thickness 20 to 22 nm. The aluminium content was varied from 30% over 35% to 40%. The thickness of the Al_{0.3}Ga_{0.7}N top layer was varied from 22 nm down to 3 nm. After the growth of the AlGaN layer the reactor was purged for 10 s while maintaining the NH₃ flow and the AlGaN growth temperature. Then silane was introduced into the reactor. The SiN is deposited in an MOCVD reactor at elevated temperatures (> 1000C) by flowing SiH4 and NH3 gasses.

A thin AlₓGa₁₋ₓN top layer with a low Al concentration results in a decrease of the 2DEG sheet carrier concentration. Lowering the Al content has a negative effect on the polarization induced sheet charge. Moreover, when the thickness of the AlₓGa₁₋ₓN barrier is reduced, the 2DEG experiences depletion from the surface states. Both effects result in a transistor with a very high sheet resistance.

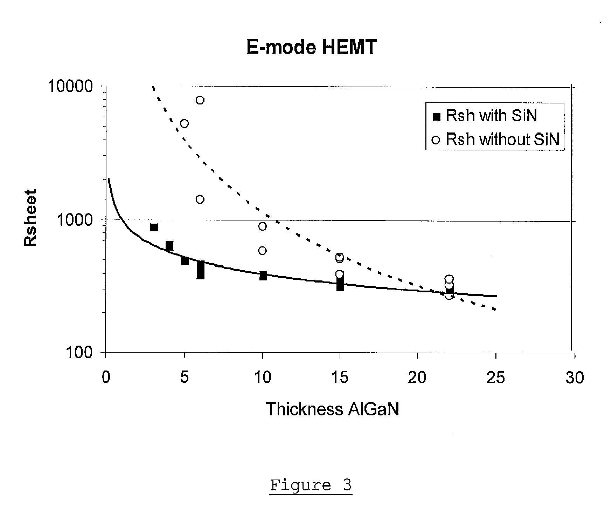

However, with an in-situ grown Si₃N₄ layer as passivation on top of the AlₓGa₁₋ₓN, the depletion from the surface states can be relieved, especially when going to very thin AlₓGa₁₋ₓN layers. The device is illustrated in Figure 1. An effect of the interaction of the SiN and the AlGaN is illustrated in Figure 3. In Figure 3, the measured sheet resistance is plotted for samples with in-situ grown Si₃N₄ as passivation. Consequently, the same samples are etched in HF to remove the Si₃N₄ and measured again. As is clear from the Figure 3, the Si₃N₄ passivation has a strong influence for very thin AlₓGa₁₋ₓN layers. For a well chosen value of the AlGaN thickness (e.g. 5nm) the removal of SiN causes the 2DEG sheet resistance to change from 300 Ω to more then 5000Ω.

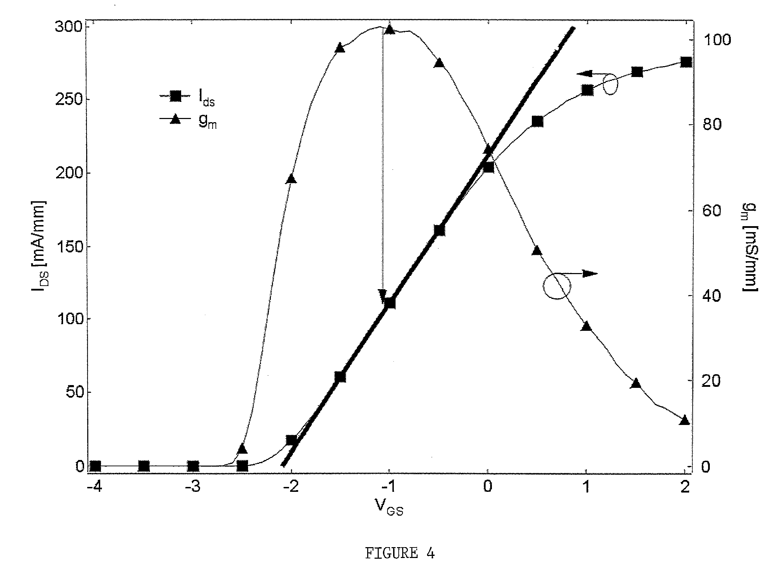

The pinch-off voltage of the channel however increases when there is a Si₃N₄ dielectric below the gate. Therefore, for processing of E-mode transistors, the Si₃N₄ under the gate is etched. For the measurement of the threshold voltage the following procedure is taken (see Figure 4). First, the point of maximum gₘ is defined. At this gate bias voltage, the tangent of the I_{ds} curve is taken and extrapolated to zero. This bias voltage defines the threshold voltage.

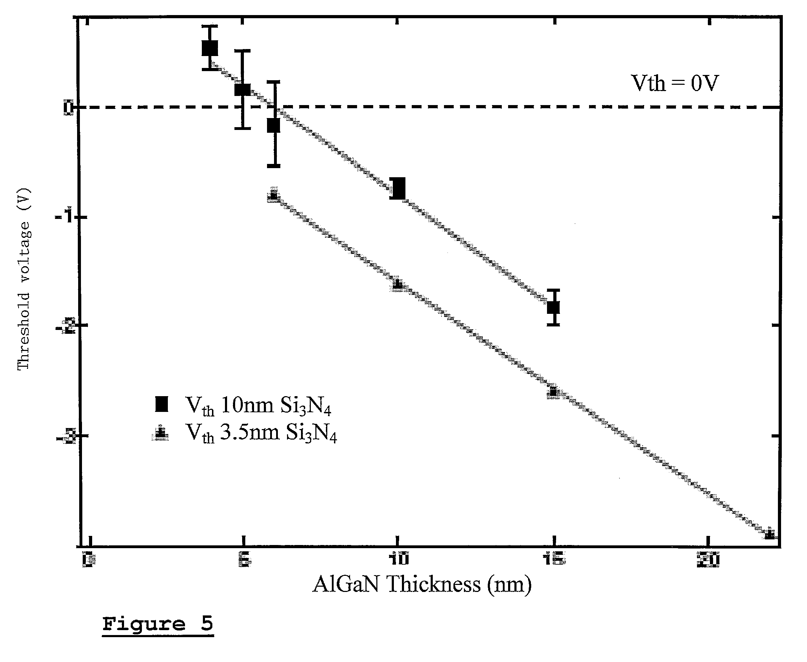

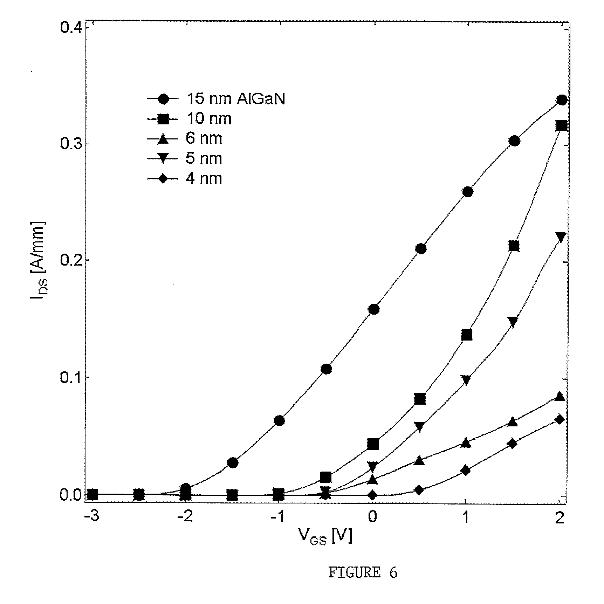

The Vₜₕ values are plotted in Figure 5 as a function of AlₓGa₁₋ₓN thickness for Si₃N₄/Al_{0.3}Ga_{0.7}N/AlN/GaN heterostructures. Two curves have been plotted for different thickness (3.5 nm versus 10 nm) of the Si₃N₄ passivation layer. The AlₓGa₁₋ₓN thickness that can be obtained for an E-mode HEMT, is a maximum of 5 nm with 10 nm Si₃N₄. The difference for both thicknesses of Si₃N₄ is related to either strain or charges in the dielectric. The Schottky barrier of the gate metal can also be used to improve Vₜₕ. An RTA anneal on the gate metal has influence on the Schottky barrier, due to alloying of the metal with AlₓGa₁₋ₓN. Therefore, the influence of anneal on the Vₜₕ is investigated. The drawback of the increased Vₜₕ is the maximum voltage on the Schottky gate metal. This is limited to +2V. When the gate voltage is higher, the Schottky gate starts to conduct. Hence, the voltage swing on the gate is limited to Vₜₕ + 2V for the 5 nm AlₓGa₁₋ₓN where Vₜₕ ~ 0V. In contrast, for a standard 22 nm AlₓGa₁₋ₓN, Vₜₕ is around -4V, so the maximum voltage applicable is Vₜₕ + 6V. Due to the limited positive voltages on the gate, the drain current is also limited. An I_{DS}-V_{GS} graph, measured at V_{DS} = 5V, is given in Figure 6 for all AlₓGa₁₋ₓN thicknesses.

The limitation in maximum gate voltage can be avoided by applying a dielectric such as SiO₂ or Al₂O₃ below the gate metal, in such a way that an insulated-gate HEMT or MOSHEMT (metal oxide semiconductor hetero structure field effect transistor) is obtained. The current can also be scaled as a function of the total gate width.

That way it is shown that an enhancement-mode Al_{0.3}Ga_{0.7}N/GaN HEMT can be made by reducing the AlₓGa₁₋ₓN thickness to 5 nm. At this thickness, the threshold voltage Vₜₕ is +0.16V. The drain-source current of these devices is limited due to the maximum voltage of +2V on the Schottky gate contact. This limitation can be solved by scaling the gate width. Another method to improve the current of these devices is the application of an insulated gate. The resulting maximum voltage at the gate contact should allow for higher currents in these devices.

Another option is recess etch of the gate region, but this introduces defect states at the AlₓGa₁₋ₓN surface. That could be mitigated by an extra RTA anneal of the AlₓGa₁₋ₓN after the etching step. However, this introduces extra processing steps. Moreover, the etch rate should be perfectly controlled.

## Claims

1. A semiconductor device comprising
- a substrate (1);
- a first active layer (2) on said substrate;
- a second active layer (3), on said first active layer (2), said second active layer having a higher band-gap when compared to said first active layer;
- a passivation layer (5) on said second active layer,
- a source contact (8) and a drain contact (9) directly on said passivation layer (5),
- at least one hole (6) in said passivation layer (5), located in between said source and drain,
- a gate contact (7) in said hole(s),
wherein a two-dimensional electron gas layer (4) is present between said active layers (2,3), outside of the location of said gate contact (7), and wherein no substantial two-dimensional electron gas layer is present between said active layers, directly underneath said gate contact (7), when the gate and source contact are at the same voltage.

2. The device according to claim 1, further comprising a dielectric layer (10), on at least a part of said passivation layer (5) and in said hole(s) (6), and wherein said gate contact (7) is present on said dielectric layer (10).

3. The device according to claim 1 or 2 wherein said substrate (1) comprises a material selected from the group consisting of silicon, sapphire, SiC, GaN, AlN, GaAs and diamond.

4. The device according to any one of claims 1 to 3, wherein said first and/or second active layer (2,3) comprise(s) a group III nitride semiconductor material.

5. The device according to claim 4 wherein said first active layer (2) comprises a material selected from the group consisting of GaN, AlGaN, InGaN, InAlGaN and BN.

6. The device according to claim 4 wherein said second active layer (3) comprises a material selected from the group consisting of AlGaN, AlInN, and AlInGaN.

7. The device according to claim any one of the preceding claims wherein said second active layer (3) has a thickness between 1 and 10 nm.

8. The device according to claim 7 wherein said second active layer (3) has a thickness between 3 and 8 nm.

9. The device according to any one of the preceding claims wherein said passivation layer (5) comprises a material comprising an electron donating element and nitrogen.

10. The device according to claim 9, wherein said passivation layer (5) comprises a material selected from the group consisting of SiN, BN, Si, CN and GeN.

11. The device according to any one of the preceding claims wherein said passivation layer (5) has a thickness between 1nm and 5000nm.

12. The device according to claim 11 wherein said passivation layer (5) has a thickness between 3nm and 20nm.

13. The device according to claim 2 wherein said dielectric layer (10) comprises a material selected from the group consisting of SiO2, A1203, Ta2O5, HfO2, ZrO2, SiN, and SiON.

14. The device according to any one of the preceding claims, wherein said passivation layer is completely removed in said hole(s) (6).

15. The device according to any one of claims 1 to 13, wherein said passivation layer is not completely removed in said hole(s) (6).

16. The device according to any one of claims 1 to 15, further comprising a spacer layer in between the first and second active layer.

17. The device according to claim 16 wherein said spacer layer is an AlN layer.

18. A method for fabricating a semiconductor device comprising the steps of
- placing a substrate (1) in a reaction chamber;
- depositing a first active layer (2) on said substrate;
- depositing a second active layer (3) on said first active layer, said second active layer having a higher band-gap when compared to said first active layer;
- depositing a passivation layer (5) on said second active layer;
- depositing a source electrode (8) and a drain electrode (9) in direct electrical contact with said passivation layer (5);
- etching at least one hole (6) in said passivation layer (5) in between said source and drain contact (8,9);
- depositing a gate contact (7) in said hole(s) (6).

19. The method according to claim 18 wherein
- said second active layer (3) has a composition, thickness and stress such that a two-dimensional electron gas layer is absent between said first active layer (2) and said second active layer (3), when no additional layers are deposited on said second active layer,
- and wherein said passivation layer (5) is applied in such a way and has material characteristics such that a two-dimensional electron gas is (4) is created between said first and said second active layer, after deposition of said passivation layer,
- and wherein said gate contact (7) is applied in such a way and has material characteristics such that no substantial two-dimensional electron gas layer is present underneath said gate contact when the gate and source contacts are at the same voltage.

20. The method according to claim 18 wherein
- said second active layer (3) has a composition, thickness and stress such that a two-dimensional electron gas layer is present between said first active layer (2) and said second active layer (3), when no additional layers are deposited on said second active layer,
- and wherein said passivation layer (5) is applied in such a way and has material characteristics such that said two-dimensional electron gas is (4) is enhanced between said first and said second active layer, after deposition of said passivation layer,
- and wherein the hole(s) (6) are etched through the complete thickness of the passivation layer (5),
further comprising the step of plasma treating the parts of the second active layer exposed by said hole(s) (6), in order to eliminate said two-dimensional electron gas layer in the locations corresponding to said holes.

21. The method according to claim 18 wherein
- said second active layer (3) has a composition, thickness and stress such that a two-dimensional electron gas layer is present between said first active layer (2) and said second active layer (3), when no additional layers are deposited on said second active layer,
- and wherein said passivation layer (5) is applied in such a way and has material characteristics such that said two-dimensional electron gas is (4) is enhanced between said first and said second active layer, after deposition of said passivation layer,
and wherein said gate contact (7) has a work function so as to eliminate the two-dimensional electron gas layer (4) underneath said gate contact (7).

22. The method according to any one of claims 18 to 21, further comprising depositing, after etching said hole(s) (6), a dielectric layer (10) on said second active layer (3), and wherein said gate contact (7) is deposited on said dielectric layer (10).

23. The method according to any one of claims 18 to 22, wherein said passivation layer (5) is deposited in-situ on said second active layer (3).

24. The method according to any one of claims 18 to 23, wherein said first active layer (2), said second active layer (3), and said passivation layer (5) are deposited by Metal Organic Chemical Vapor Deposition growth (MOCVD).

25. A method for using a semiconductor device according to any one of claims 1 to 17 comprising
- applying a voltage between said source and drain contacts (8,9), such that said drain electrode (9) has a higher potential when compared to said source (8);
- applying a positive voltage above a threshold voltage on said gate contact (7) relative to said source contact potential such that said a two-dimensional electron gas layer is created between said first active layer and said second active underneath said gate contact, thereby realizing a current between source and drain contacts.
